# EUROPÄISCHE PATENTSCHRIFT

(11) **EP 0 416 284 B1**
(45) Veröffentlichungstag und Bekanntmachung des Hinweises auf die Patenterteilung: **15.03.1995**
(21) Anmeldenummer: 90114728.0
(22) Anmeldetag: 31.07.1990
(51) Int. Cl.: H01L 31/167, H01L 31/0216, H01L 27/144

(54) **Optokoppler**
Optocoupler
Coupleur optique

(30) Priorität: 07.09.1989 DE 3929795
(43) Veröffentlichungstag der Anmeldung: 13.03.1991
(73) Patentinhaber: SIEMENS AKTIENGESELLSCHAFT, 80333 München (DE)
(72) Erfinder: Stein, Karl-Ulrich, Dr.-Ing., D-8025 Unterhaching (DE)

(56) Entgegenhaltungen:
- EP-A- 0 002 752
- EP-A- 0 279 492
- FR-A- 2 590 750
- FR-A- 2 590 750
- GB-A- 2 188 484

## Beschreibung

Die Erfindung betrifft einen Optokoppler nach dem Oberbegriff von Anspruch 1; ein derartiger Optokoppler ist beispielsweise aus FR-A-2 590 750 bekannt.

Derartige Optokoppler sind bekannt. Sie dienen der rückwirkungsfreien Signalübertragung zwischen zwei galvanisch getrennten Schaltkreisen, und zwar einem Primär- und einem Sekundärkreis. Sie bestehen primärseitig aus einem licht,emittierenden Halbleiterbauelement, beispielsweise einer lichtemittierenden Halbleiterdiode (LED), und sekundärseitig aus einem lichtempfangenden Halbleiterbauelement, beispielsweise einer Photodiode oder einem Phototransistor. Diese Bauelemente sind miteinander optisch verkoppelt. Als Koppelmedium wird beispielsweise ein transparenter Kunststoff verwendet.

Die heute meist verbreiteten Optokoppler weisen sekundärseitig einen bipolaren Phototransistor auf. Damit stellt der Ausgang des Kopplers einen veränderbaren Widerstand mit Transistorkennlinie dar.

Für die Ansteuerung von Feldeffekt-Transistoren, insbesondere von MOS-Transistoren, und zwar ohne zusätzliche Spannungsquelle wird allerdings ein Optokoppler benötigt, der sekundärseitig eine Spannung in der Größenordnung von 5Volt abgibt. Ein derartiger Koppler wird insbesondere für einen Testzugriff je Fernsprechteilnehmerleitung in einem rechnergesteuerten Fernsprechvermittlungssystem mehrfach benötigt.

Optokoppler dieser Art mit Spannungsausgang erfordern die Serienschaltung von mehreren Photoelementen, d.h. aktiven Zwei polen mit einem pn-Übergang, die einen relativ geringen Innenwiderstand aufweisen. Sie können diskret aufgebaut sein, oder durch eine Hybridtechnik, die mehrere Chips zusammenfügt. Will man die Photoelemente monolithisch integrieren, so muß man die einzelnen Photoelemente durch dielektrische Isolation voneinander trennen. Ebenfalls anwendbar sind Photoelemente in amorphen oder kristallinen Halbleiterschichten auf Isolatoren, z.B. amorphes Silizium auf Siliziumdioxidschichten. Alle diese Möglichkeiten sind allerdings aufgrund des komplexen Aufbaus kompliziert und mit hohem Zeit- bzw. Kostenaufwand bei der Herstellung verbunden.

Der Erfindung liegt die Aufgabe zugrunde, einen Optokoppler mit Spannungsausgang zu schaffen, der sich auf relativ einfache Weise kostengünstig realisieren läßt, der mit weiteren Bauelementen integrierbar ist und der vor allem zur Ansteuerung von Feldeffekt-Transistoren ohne zusätzliche Spannungsquelle geeignet und damit insbesondere für einen Testzugriff in modernen Fernsprechvermittlungssystemen verwendbar ist.

Diese Aufgabe wird bei einem Optokoppler der eingangs genannten Art erfindungsgemäß durch die Merkmale des kennzeichnenden Teiles von Anspruch 1 gelöst.

Der Halbleiterchip besteht dabei aus einer partiell dünn geätzten Silizium-Substratscheibe, in der die einzelnen Photoelemente im dünngeätzten Teil durch Trenndiffusion realisiert sind. Die durch die Trenndiffuision gebildeten pn-Übergänge werden dabei durch eine Metallisierung gegen Lichteinfall geschützt. Die Schichtdicke des Siliziumchips beträgt im Bereich der Photoelemente zweckmäßig ungefähr 15»m.

Die mit der Erfindung erzielten Vorteile bestehen insbesondere darin, daß das als Empfänger dienende Halbleiterbauelement des Optokopplers als Serienschaltung von Photoelementen in einem aus Silizium bestehenden Halbleiterchip integriert ist. Dabei wird im Bereich der Photoelemente die Siliziumscheibe in einem Verfahren, wie es beispielsweise aus EP-A-0 279 492 bekannt ist, bis auf eine dünne, zweckmäßig ca. 15»m dicke, Siliziumschicht abgeätzt. In dieser Siliziumschicht werden die einzelnen Photoelemente mit Trenndiffusion hergestellt. Die pn-Übergänge dieser Trenndiffusion werden durch die sowieso nötige Metallisierung vollständig gegen Lichteinfall geschützt. Der besondere Vorteil dieser Anordnung besteht darin, daß das partiell dünngeätzte Siliziumsubstrat, das wie ein üblicher Chip getestet, vereinzelt und gebondet wird, wesentlich billiger ist als jede Lösung mit einem Substrat mit dielektrischer Isolation. Ein weiterer Vorteil besteht darin, daß sich in dieser Technologie neben Photoelementketten auch laterale Bauelemente wie Widerstände oder MOS-Transistoren und - im Rahmen der für die Dünnschichtherstellung erforderlichen Epitaxie - auch vertikale Schaltelemente wie Leistungs-MOS-Transistoren herstellen lassen.

Für einen Optokoppler mit einem oder mehreren Spannungsausgängen werden eine oder mehrere Serienschaltungen von Photoelementen - soweit nötig mit weiteren Schaltelementen - monolithisch in einem Empfängerchip vereint. Er kann damit eine an sich bekannte Schaltung für einen Ansteueroptokoppler enthalten. Dieser Empfängerchip wird samt einer LED als Lichtsender in der üblichen Weise in einem Optokoppler verpackt.

Anhand von in den Figuren der Zeichnung dargestellten Ausführungsbeispielen wird die Erfindung im folgenden weiter erläutert. Es zeigen
- FIG 1: eine Photoelement-Serienschaltung im dünnen Bereich eines Silizium-Empfängerchips im Schnitt,
- FIG 2: eine Draufsicht auf die Photoelement-Serienschaltung der FIG 1,
- FIG 3: einen Optokoppler schematisch im Schnitt und
- FIG 4: eine Schaltung eines Ansteuer-Optokopplers für einen Fernsprechteilnehmer-Testzugriff.

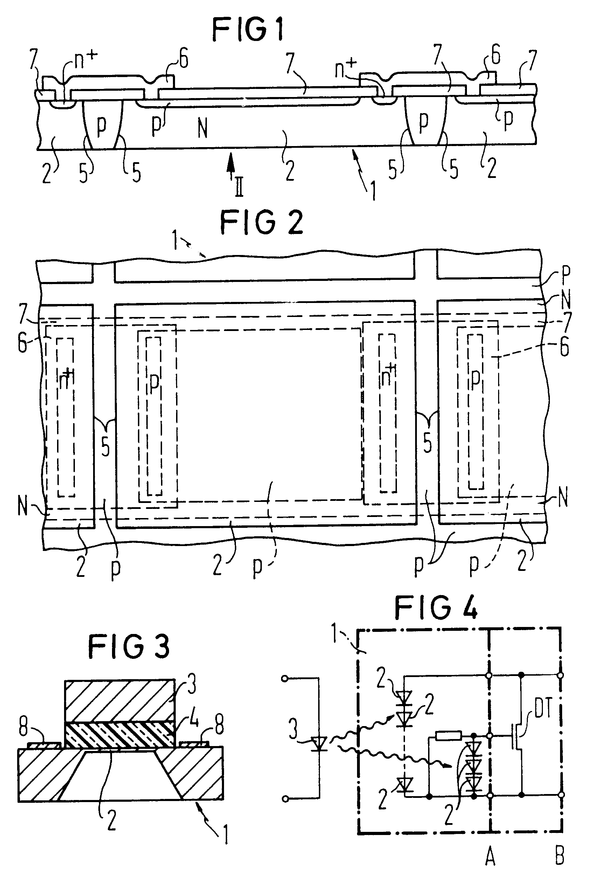

Das in den Figuren 1 und 2 im Ausschnitt dargestellte lichtempfangende Halbleiterbauelement 1 bildet einen Teil des erfindungsgemäßen Optokopplers mit Spannungsausgang. Dieser Empfängerteil ist ein Siliziumchip 1. Der dargestellte dünne Bereich ist Teil einer n-dotierten Siliziumsubstratscheibe, die im Bereich der Photoelemente 2 in einem Verfahren, wie es für Drucksensoren angewandt wird, bis auf eine nur ca. 15»m dicke, n-leitende Siliziumschicht abgeätzt wird. In dieses n-dotierte Siliziumsubstrat werden p-leitende Bereiche zum Bilden der Photoelemente 2 eindiffundiert. Das n-dotierte Siliziumsubstrat mit seinen p-leitenden Inseln wird durch Trenndiffusionen, in diesem Fall p-Diffusion, so aufgeteilt, daß die dabei gebildeten pn-Übergänge bzw. Trennwände 5 eine Vielzahl von Photoelementen 2 begrenzen. Die Oberfläche der n-Siliziumsubstratscheibe ist mit einer Siliziumoxidschicht 7 abgedeckt, die als Oberflächenpassivierung dient. Diese Schicht 7 weist zur Kontaktierung der Photoelemente 2 an den entsprechenden Stellen Aussparungen auf, so daß eine zweckmäßig aus Aluminium bestehende Metallisierungs- bzw. Kontaktschicht 6 mit den jeweiligen p-Gebieten direkt und den n-Gebieten über jeweils ein n⁺-Kontakt-Diffusionsgebiet so in Verbindung gebracht werden kann, daß die angestrebte Serienschaltung gebildet wird. Die Kontaktmetallisierung 6 erfüllt dabei noch einen weiteren Zweck, indem sie auf dem Empfängerchip 1 so angebracht ist, daß sie die pn-Übergänge bzw. Trennwände 5, die durch die Trenndiffusion im Chip 1 erzeugt worden sind, vollständig gegen störenden Lichteinfall schützt, ohne die zu beleuchtenden Flächen der Photoelemente 2 von dem vom lichtemittierenden Halbleiterbauelement herrührenden Licht zu verdecken.

Der in FIG 3 rein schematisch dargestellte Optokoppler verdeutlicht insbesondere den Querschnitt des Empfängerchips 1 mit der Photoelement-Serienschaltung. Der Empfängerchip 1 ist über ein geeignetes Koppelmedium 4, beispielsweise ein lichttransparentes, elektrisch isolierendes Kunstharz mit dem Senderchip 3, beispielsweise einer LED, optisch verkoppelt. Die Photoelemente 2 sind in den dünnen Stegteil des Empfängerchips 1 in Serie geschaltet integriert. Die beiden Kontaktierungen 8 stellen den Spannungsausgang des Optokopplers dar und sind Teile der Kontaktmetallisierung, die zur Serienschaltung der Photoelemente 2 verwendet wird. Neben den Photoelementen werden vorzugsweise im Bereich des nicht gedünnten Halbleiterchips 1 weitere integrierte Schaltelemente, vorzugsweise unter Verwendung derselben Prozeßschritte wie für die Photoelemente 2, hergestellt. Diese Schaltelemente sind für die Anwendungen der Optokoppler in der Kommunikationstechnik vorzugsweise MOS-Transistoren. Sie können als laterale oder vertikale Transistoren vom Enhancement- oder Depletion-Typ ausgebildet sein.

Eine beispielsweise neben die Photoelemente 2 im Empfängerchip 1 monolithisch integrierbare Schaltung ist in FIG 4 dargestellt. Diese Schaltung eines Ansteuer-Optokopplers für einen Fernsprechteilnenmer-Testzugriff weist zwei mögliche Schnittstellen (A und B) auf, die durch strichpunktierte Linien angedeutet sind: A ist die Schnittstelle für einen externen Pull-down-Depletion-Transistor DT, und B ist die Schnittstelle für einen integrierten Depletion-Transistor DT. Mit den geschlängelten Pfeilen ist die von dem Senderchip (LED) 3 in Richtung auf die Photoelemente 2 des Empfängerchips emittierte optische Strahlung angedeutet.

## Patentansprüche

1. Optokoppler mit einem lichtemittierenden Halbleiterbauelement und einem lichtempfangenden Halbleiterbauelement, die über ein elektrisch isolierendes, lichtdurchlässiges Koppelmedium miteinander verbunden sind, und bei dem das lichtempfangende Halbleiterbauelement ein Halbleiterchip ist, in den mehrere in Serie geschaltete Photoelemente integriert sind, **dadurch gekennzeichnet**, daß der Halbleiterchip (1) aus einer Silizium-Substratscheibe besteht, die einen dünnen mittleren Stegteil und dickere Randbereiche aufweist, daß die einzelnen Photoelemente (2), mittels durch den Stegteil hindurch verlaufende und durch eine Metallisierung (6) gegen Lichteinfall geschützte pn- Übergänge (5) voneinander getrennt, in den mittleren Stegteil integriert sind, und daß in den Halbleiterchip (1) weitere Halbleiterschaltelemente integriert sind.

2. Optokoppler nach Anspruch 1, **dadurch gekennzeichnet**, daß die Schichtdicke des Halbleiterchips (1) im Bereich der Photoelemente (2) ungefähr 15»m beträgt.

3. Optokoppler nach einem der Ansprüche 1 oder 2, **dadurch gekennzeichnet**, daß das lichtempfangende Halbleiterbauelement ein Halbleiterchip (1) ist, in den mehrere Serienschaltungen von Photoelementen (2) integriert sind.

4. Optokoppler nach einem der Ansprüche 1 bis 3, **dadurch gekennzeichnet**, daß in den Randbereichen des Halbleiterchips (1) weitere Halbleiterschaltelemente integriert sind.

5. Optokoppler nach Anspruch 4, **dadurch gekennzeichnet**, daß die Schaltelemente Feldeffekttransistoren sind.

6. Optokoppler nach Anspruch 5, **dadurch gekennzeichnet**, daß der Optokoppler einen integrierten Feldeffekttransistor (DT) im Ausgang hat.

## Claims

1. Optocoupler having a light-emitting semiconductor component and a light-receiving semiconductor component, which are connected to each other via an electrically insulating coupling medium transparent to light, and in which the light-receiving semiconductor component is a semiconductor chip in which a plurality of photoelements connected in series are integrated, characterized in that the semiconductor chip (1) comprises a silicon substrate wafer which has a thin central web part and thicker edge regions, in that the individual photo elements (2), separated from each other by means of pn-junctions (5) extending through the web part and protected against incident light by metallization (6), are integrated into the central web part, and in that further semiconductor circuit elements are integrated into the semiconductor chip (1).

2. Optocoupler according to Claim 1, characterized in that the layer thickness of the semiconductor chip (1) is about 15 »m in the region of the photoelements (2).

3. Optocoupler according to one of Claims 1 or 2, characterized in that the light-receiving semiconductor component is a semiconductor chip (1) in which a plurality of series circuits of photoelements (2) are integrated.

4. Optocoupler according to one of Claims 1 to 3, characterized in that further semiconductor circuit elements are integrated into the edge regions of the semiconductor chip (1).

5. Optocoupler according to Claim 4, characterized in that the circuit elements are field-effect transistors.

6. Optocoupler according to Claim 5, characterized in that the optocoupler has an integrated field-effect transistor (DT) in the output.

## Revendications

1. Coupleur opto-électronique comportant un composant photoémissif à semiconducteurs et un composant photorécepteur à semiconducteurs, qui sont reliés entre eux par l'intermédiaire d'un milieu de couplage laissant passer la lumière et électriquement isolant, et dans lequel le composant photorécepteur à semiconducteurs est une puce à semiconducteurs, dans laquelle sont intégrés plusieurs éléments photosensibles branchés en série, caractérisé par le fait que la puce à semiconducteurs (1) est constituée d'une tranche de substrat en silicium, qui a une âme médiane mince et des zones marginales plus épaisses, que les différents éléments photosensibles (2) sont intégrés à l'âme médiane, en étant séparés les uns des autres au moyen de jonctions pn (5), qui s'étendent au travers de l'âme et sont protégées par une métallisation (6) vis-à-vis de la lumière incidente, et que d'autres éléments de commutation à semiconducteurs sont intégrés à la puce à semiconducteurs (1).

2. Coupleur opto-électronique suivant la revendication 1, caractérisé par le fait que l'épaisseur de la couche de la puce à semiconducteurs (1) dans la zone des éléments photosensibles (2) est égale à environ 15 »m.

3. Coupleur opto-électrique suivant l'une des revendications 1 ou 2, caractérisé par le fait que le composant photorécepteur à semiconducteurs est une puce à semiconducteurs (1), dans laquelle sont intégrés plusieurs montages en série d'éléments photosensibles (2).

4. Coupleur opto-électronique suivant l'une des revendications 1 à 3, caractérisé par le fait que d'autres éléments de commutation à semiconducteurs sont intégrés aux zones marginales de la puce à semiconducteurs (1).

5. Coupleur opto-électronique suivant la revendication 4, caractérisé par le fait que les éléments de commutation sont des transistors à effet de champ.

6. Coupleur opto-électronique suivant la revendication 5, caractérisé par le fait que le coupleur opto-électronique a, dans sa sortie, un transistor à effet de champ intégré (DT).
